Europäisches Patentamt

**European Patent Office**

Office européen des brevets

(19)

(11) Veröffentlichungsnummer : **0 128 154**
**B1**

(12) **EUROPÄISCHE PATENTSCHRIFT**

(45) Veröffentlichungstag der Patentschrift :
22.10.86

(21) Anmeldenummer : 83903492.3

(22) Anmeldetag : 25.11.83

(86) Internationale Anmeldenummer :
PCT/CH 83/00131

(87) Internationale Veröffentlichungsnummer :
WO/8402444 (21.06.84 Gazette 84/15)

(51) Int. Cl.⁴ : **H 05 K   7/20**

(54) **MIT WÄRMELEITFÄHIGER PASTE ODER FLÜSSIGKEIT GEFÜLLTER FLACHBEUTEL.**

(30) Priorität : 16.12.82 CH 7325/82

(43) Veröffentlichungstag der Anmeldung :
19.12.84 Patentblatt 84/51

(45) Bekanntmachung des Hinweises auf die Patenterteilung : 22.10.86 Patentblatt 86/43

(84) Benannte Vertragsstaaten :
CH DE FR GB LI NL SE

(56) Entgegenhaltungen :
DE-A- 2 800 080
US-A- 3 586 102
IBM Technical Disclosure Bulletin, volume 19, No. 8,
January 1977, New-York (US) E.B. Hultmark et al.:
"Thermal Enhancement of Modules", page 3127

(73) Patentinhaber : Hasler AG
Belpstrasse 23
CH-3000 Bern 14 (CH)

(72) Erfinder : ULRICH, Bohdan
Holzmattweg 4
CH-3122 Kehrsatz (CH)

(74) Vertreter : Schwerdtel, Eberhard, Dr.
c/o Hasler AG Belpstrasse 23
CH-3000 Bern 14 (CH)

**Beschreibung**

Die Erfindung betrifft einem mit wärmeleitfähiger Paste (18) oder Flüssigkeit gefüllten, aus Folien (14, 15) zusammengesetzten, allseitig geschlossenen Flachbeutel (11).

Der Wärmeübergangs-Widerstand zwischen zwei festen Körpern ist umso geringer, je dünner der lufterfüllte Zwischenraum bzw. Spalt zwischen den Kontaktflächen der Körper ist. Zur Verringerung des Wärmeübergangs-Widerstandes zwischen Körpern, die nur zeitweilig miteinander in Kontakt stehen, ist es daher bekannt, die Kontaktflächen planzuschleifen oder zu polieren. Ist dies zu aufwendig, so ist es weiter bekannt, den Spalt zwischen den Kontaktflächen durch eine Wärmekontaktpaste auszufüllen. Diese vermindert aufgrund ihrer gegnüber Luft beträchtlich höheren Wärmeleitfähigkeit den Wärmeübergangs-Widerstand der jeweiligen Spalte.

Wärmekontaktpasten sind in der Handhabung relativ umständlich, da die Pasten hochviskos und klebrig sind. Daher wurde versucht, durch Einschliessen der Paste in einen Beutel hier eine Verbesserung der Eigenschaften zu gewinnen. So ist beispielsweise aus der Schrift US 3 586 102 ein derartiger Kunststoffbeutel bekannt, der zum Herstellen von Wärmebrücken zwischen den Bauelementen einer Leiterplatte und einer Wärmeableitplatte dient.

Weiter ist aus IBM Disclosure Bulletin, Band 19, Nr. 8, Januar 1977, Seite 3127 ein Kunststoffbeutel bekannt, der mit einem flüssigen Metall gefüllt ist. Auch dieser Beutel dient zum Ableiten der Wärme von elektrischen Bauelementen zu einer Wärmesenke.

Für die Verringerung des Wärmeleitwiderstandes in senkrechten Spalten bei geringem Temperaturgradient sind weder offene Wärmeleitpasten noch Beutel der gezeigten Art geeignet. Offene Pasten laufen mit der Zeit aus dem Spalt aus und beeinflussen damit den Widerstand unkontrollierbar. Die Beutel dagegen sind zu voluminös und der Kunststoff der Beutelfolien bedingt eine nicht zu vernachlässigende Erhöhung des Gesamtwärmeleitwiderstandes. Es ist daher die Aufgabe der Erfindung, ein in der Handhabung und Gebrauchstüchtigkeit günstiges Füllmaterial anzugeben, das besonders bei senkrechten, dünnen Spalten zwischen relativ grossen, ebenen Flächen einsetzbar ist und seine Wirkung über lange Zeit aufrechterhält.

Die Lösung dieser Aufgabe ist gekennzeichnet durch den kennzeichnenden Teil von Anspruch 1. Anspruch 6 kennzeichnet die bevorzugte Verwendung des Füllmaterials. Die anderen Ansprüche geben Ausgestaltungen der Erfindung wieder.

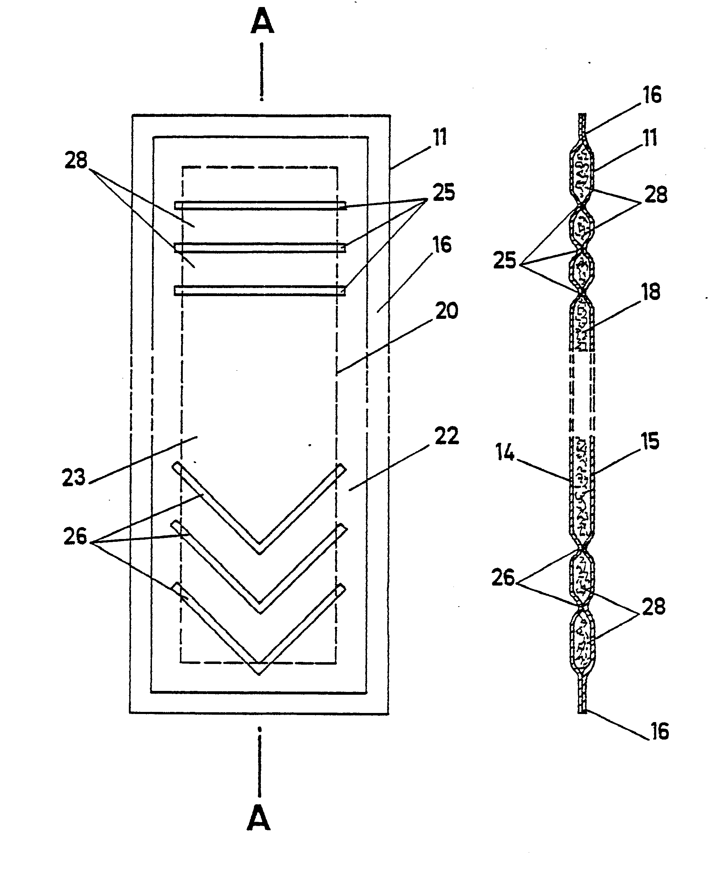

Im folgenden wird die Erfindung anhand einer einzigen Doppelfigur beispielsweise näher beschrieben. Die Figur zeigt links eine Aufsicht auf und rechts einen Schnitt längs der Linie A-A durch einen flachen Beutel 11. Dieser Beutel 11 ist beispielsweise aus zwei Folien 14 und 15 durch Verkleben oder Verschweissen gebildet. 16 bezeichnet den Verschweissungsrand, der den Beutel allseitig hermetisch verschliesst.

Die Folien 14 und 15 bestehen aus gut wärmeleitfähigem Material, insbesondere aus Metall, z. B. Aluminium. Sie sind relativ dünn (z. B. 1/10 mm) und anschmiegsam. Im Inneren des Beutels 11 ist eine gut wärmeleitfähige Paste 18 enthalten.

Gestrichelt ist eine Bereichsgrenze 20 dargestellt. Der bezüglich dieser Grenze innere Bereich 23 dient zum Ausfüllen des Spaltes zwischen zwei starren Körpern zum Zwecke des vebesserten Wärmeaustausches zwischen diesen Körpern. Der Bereich 22 zwischen der Grenze 20 und dem Verschweissungsrand 16 dagegen darf nicht im Spalt liegen, sondern muss Platz zur Ausdehnung haben. Sein aufblähbares Volumen ist so bemessen, dass er die gesamte im Beutel 11 enthaltene Wärmeleitpaste 18 aufnehmen kann.

Die bevorzugte Verwendung der Beutel 11 erfolgt in Elektronikgestellen mit Flüssigkeitskühlung, wie sie beispielsweise aus dem Schweizerischen Patentgesuch Nr. 3 683/82-0 bekannt sind. Bei diesen Gestellen besteht die Aufgabe, zwischen gestellinternen Rohren zum Abführen der im Gestell entstehenden Verlustwärme und den die Elektronikschaltungen enthaltenden und die Verlustwärme erzeugenden, auswechselbaren Einschüben jeweils einen einwandfreien und langfristig konstanten Wärmekontakt herzustellen. Hierzu wird je ein Beutel 11 zwischen den senkrecht angeordneten Rohren und der Rückwand jedes einzuschiebenden Einschubs angeordnet. Beim Einschieben eines Einschubs in das Elektronikgestell wird der jeweilige Beutel 11 zwischen der Rückwand des Einschubs und den Rohren eingequetscht. Hierbei fliesst die Paste 18, die sich anfangs im inneren Bereich 23 des Beutels befindet, teilweise in den Aussenbereich 22 des Beutels 11. Die Folien 14 und 15 schmiegen sich an die Rohre und die Rückwand an und die Paste 18 füllt die Unebenheiten des Spaltes aus. Die weggequetschte Paste 18 bleibt im Aussenbereich 22 des Beutels 11 gelagert. Der Endzustand ist erreicht, wenn an wenigstens einer Stelle zwischen den Rohren und der Rückwand nur noch die nackten Folien 14 und 15 liegen und die Paste 18 vollständig weggequetscht ist.

Bevorzugt weist der Beutel 11 in seinem inneren Bereich 23 Querverschweissungen oder -verklebungen 25, 26 auf. Diese Querverschweissungen 25, 26 verbinden die beiden Folien 14 und 15 streifenweise und bilden Taschen 28, die untereinander nur durch relativ enge Durchgänge oder überhaupt nicht verbunden sind.

Die Querverschweissungen können geradlinig (25) sein oder bevorzugt V- oder U-förmig gebogen (26). Bei Verwendung der Beutel 11 in senkrechter Lage verhindert die V- bzw. U-Form, sofern die Spitze nach unten weist, wirkungsvoll das Auslaufen der Paste 18 nach unten. Aus diesem Grund kann statt einer wärmeleitfähigen Paste 18 im Beutel 11 auch ein wärmeleitfähiger Stoff geringerer Viskosität, z. B. eine Flüssigkeit, eingesetzt werden. Eine Flüssigkeit hat gegenüber einer Paste den Vorteil besserer Handhabbarkeit und rascherer Anpassung an den auszufüllenden Spalt. Ausserdem läuft eine Flüssigkeit selbständig und rasch in ihre Ausgangsposition, d. h. in den mittleren Bereich 23 zurück, wenn beispielsweise eine Elektronikeinschub im beschriebenen Elektronikgestell ausgewechselt wird. Eine Paste muss in diesem Fall durch einen eigenen Arbeitsvorgang in den mittleren Bereich zurückgedrückt werden.

Weist der Beutel 11 geschlossene Taschen 28 auf, so muss jede dieser Taschen einen Unterbereich aufweisen, der dem inneren Bereich 23 des Beutels zugehört und wenigstens einen zweiten Unterbereich, der dem Aussenbereich 22 des Beutels 11 zugehört. Hierbei muss der zweite Unterbereich jeweils die gesamte in der jeweiligen Tasche 28 enthaltene Paste oder Flüssigkeit 18 aufnehmen können. Geschlossene Taschen 28 haben unter anderem den Vorteil, dass im Fall eines Lecks jeweils nur eine Tasche und nicht der ganze Beutel 11 betroffen ist.

Für die Gebrauchstüchtigkeit wichtig ist, dass der Beutel 11 ausschliesslich Paste oder Flüssigkeit 18 enthält. Er sollte daher kein Gas, z. B. Luft, mit einschliessen, das störende Blasen erzeugen könnte. Der Beutel 11 ist daher vor dem Verschliessen zu evakuieren und das Volumen der Paste oder Flüssigkeit 18 muss klein sein gegenüber dem maximal möglichen Fassungsvolumen des Beutels 11.

Der Aussenbereich 22 ist keine scharf umrissene Grösse. Er kann beliebig geformt und dort plaziert sein, wo er seine Funktion, nämlich die überschüssige Paste oder Flüssigkeit 18 aufzunehmen, am besten erfüllt. Insbesondere kann er einseitig an einer der Längsseiten des Beutels liegen.

**Patentansprüche**

1. Mit wärmeleitfähiger Paste (18) oder Flüssigkeit gefüllter, aus Folien (14, 15) zusammengesetzter, allseitig geschlossener Flachbeutel (11), dadurch gekennzeichnet,
— dass die Folien Metallfolien (14, 15) sind,
— dass der Flachbeutel (11) ohne Einschluss eines Gases oder sonstigen Stoffes nur zu einem geringen Bruchteil seines maximal möglichen Volumens mit der Paste (18) oder Flüssigkeit gefüllt ist, und
— dass der Flachbeutel (11) durch streifenweises Verbinden seiner Folien in Taschen (28) unterteilt ist.

2. Flachbeutel nach Anspruch 1, dadurch gekennzeichnet, dass die Metallfolien (14, 15) Aluminiumfolien sind.

3. Flachbeutel nach Anspruch 1, dadurch gekennzeichnet, dass die Taschen (28) miteinander in Verbindung stehen.

4. Flachbeutel nach Anspruch 1, dadurch gekennzeichnet, dass die Taschen (28) in sich geschlossen sind.

5. Flachbeutel nach Anspruch 1, dadurch gekennzeichnet, dass die Taschen (28) V- oder U-förmig ausgebildet sind.

6. Verwendung des Flachbeutels (11) nach Anspruch 1, als Füllmaterial zum Ausfüllen des Spalts zwischen zwei starren, zum Zweck des Wärmeaustausches zusammengefügten, im wesentlichen ebenen Körpern, dadurch gekennzeichnet,
— dass der zwischen die zu kontaktierenden Flächen eingelegte Beutel (11) grösser ist als wenigstens eine der Flächen, derart,
— dass wenigstens an einer Seite des Beutels (11) ein solcher Bereich des Beutels (11) freiliegend bleibt, der die gesamte Paste (18) oder Flüssigkeit aufzunehmen gestattet,
— und dass der Beutel (11) zwischen den zu kontaktierenden Flächen so weitgehend eingeklemmt ist, dass an wenigstens einer Stelle die zu kontaktierenden Flächen nur durch die nackten Folien (14, 15) getrennt sind.

7. Verwendung nach Anspruch 5, dadurch gekennzeichnet,
— dass die zu kontaktierenden Flächen im wesentlichen senkrecht stehend sind,
— und dass der Beutel (11) so eingelegt ist, dass seine Taschen (28) nach unten geschlossen sind.

**Claims**

1. A flat bag (11), constructed of foil sheets (14, 15) sealed on all sides and filled with a heat conducting paste (18) or liquid, characterized in
— that the foil sheets are metal foil sheets (14, 15),
— that the flat bag (11) without the inclusion of a gas or an other material is filled to only a small fraction of its maximum possible volume with the paste (18) or liquid, and
— that through stripwise joining of the foil sheets (14, 15), the flat bag (11) is divided into pockets (28).

2. Flat bag according to claim 1, characterized in that the metal foil sheets (14, 15) are aluminium foil sheets.

3. Flat bag according to claim 1, characterized in that the pockets (28) are connected to each other.

4. Flat bag according to claim 1, characterized in that the pockets (28) are each self-contained.

5. Flat bag according to claim 1, characterized in that the pockets (28) are formed in a V- or a U-shape.

6. Use of the flat bag (11) according to claim 1, as filling material for filling the gap between two rigid, essentially flat-surfaced bodies placed together with the aim of an exchange of heat, characterized in that
— the bag (11) laid between the two surfaces to be placed together is larger than at least one of the surfaces, in such a way

— that on at least one side of the bag (11) such an area of the bag (11) remains exposed as to be capable of accomodating the whole of the paste (18) or liquid, and

— that the bag (11) is so extensively clamped between the two surfaces that in at least one place the two surfaces to be placed together are separated only by the two bare foil sheets (14, 15).

7. Use according to claim 5, characterized in that,

— the surfaces to be placed together stand essentially perpendicular, and

— that the bag (11) is inserted such that its pockets (28) are closed at the bottom.

**Revendications**

1. Sachet plat (11) fermé de toutes parts, composé de feuilles (14, 15), rempli d'une pâte (18) ou d'un liquide conducteur de la chaleur, caractérisé en ce que :

— les feuilles (14, 15) sont des feuilles de métal,

— le sachet plat (11) est rempli, sans inclusion de gaz, ni substance analogue, et pour une faible fraction seulement de son volume maximum possible, avec la pâte (18) ou le liquide, et

— le sachet plat (11) est divisé par des éléments de liaison en forme de bandes de ses feuilles, en poches (28).

2. Sachet plat suivant la revendication 1, caractérisé en ce que les feuilles métalliques (14, 15) sont des feuilles d'aluminium.

3. Sachet plat suivant la revendication 1, caractérisé en ce que les poches (28) communiquent entre elles.

4. Sachet plat suivant la revendication 1, caractérisé en ce que les poches (28) sont fermées sur elles-mêmes.

5. Sachet plat suivant la revendication 1, caractérisé en ce que les poches (28) sont réalisées en forme de V ou de U.

6. Utilisation du sachet plat (11) suivant la revendication 1, comme matériel de remplissage pour combler la fente entre deux corps rigides sensiblement plans assemblés pour un échange de chaleur, caractérisée en ce que :

— le sachet (11) inséré entre les surfaces dont le contact doit être assuré est plus grand qu'au moins l'une des surfaces de telle façon que,

— au moins sur un côté du sachet (11), il reste libre une zone du sachet (11) telle qu'elle puisse recevoir la totalité de la pâte (18) ou du liquide, et que

— le sachet (11) soit serré entre les surfaces dont le contact doit être assuré dans une mesure telle que, sur au moins un point, les surfaces à mettre en contact, sont séparées seulement par les surfaces (14, 15) nues des feuilles.

7. Utilisation suivant la revendication 5, caractérisée en ce que :

— les surfaces à mettre en contact sont essentiellement verticales,

— le sachet (11) est inséré de telle façon que ses poches (28) sont fermées vers le bas.